# EUROPEAN PATENT APPLICATION

(11) **EP 4 776 783 A1**
(43) Date of publication of application: **15.07.2026**
(21) Application number: 26150394.0
(22) Date of filing: 06.01.2026
(51) Int. Cl.: H10B 61/00, H10N 50/01, H10N 50/10, G11C 11/16

(54) **HIGH DENSITY MAGNETORESISTIVE RANDOM ACCESS MEMORY AND METHODS OF FABRICATION THEREOF**

(30) Priority: 09.01.2025 US 202519014947
(71) Applicant: NXP B.V., 5656 AG Eindhoven (NL)
(72) Inventor: CHIN, Hock Chun, 5656AG Eindhoven (NL); CHEN, Yu, 5656AG Eindhoven (NL)
(74) Representative: Schwarzweller, Thomas

(57) **Abstract**

A three-dimensional (3D) magnetoresistive random access memory (MRAM) device includes a plurality of stacked cells (106, 106-1, 106-2, ...), a plurality of stacked insulating layers (120), and a first interconnect structure (116) of a first type. The plurality of cells (106, 106-1, 106-2, ...) are stacked in a direction perpendicular to a major surface of a substrate (504) of the 3D MRAM device. Each cell of the first plurality of cells (106, 106-1, 106-2, ...) is separated by an insulating layer of the plurality of insulating layers (120) from another cell of the plurality of cells. Each cell of the first plurality of cells (106, 106-1, 106-2, ...) includes a magnetic tunnel junction (MTJ) structure (108) and a second interconnect structure (130) of a second type configured to interface with the MTJ structure (108) of the cell. The first interconnect structure (116) is oriented orthogonally to the second interconnect (130) of each cell of the plurality of cells, and extends through the plurality of cells (106, 106-1, 106-2, ...) to interface with the MTJ structure (108) in each cell.

## Description

### BACKGROUND

Magnetoresistive random access memory (MRAM) is a non-volatile memory technology that offers a combination of fast write speeds, high endurance, and non-volatility, making it suitable for a wide range of applications. Unlike certain other memory technologies, such as dynamic random access memory (DRAM), MRAM retains data even in the absence of power, while providing the durability to withstand frequent read and write cycles. These characteristics position MRAM as a suitable option for use in storage, computing, and embedded systems, where reliable, high-speed data retention is important.

Despite its advantages, conventional MRAM architectures face limitations in terms of memory density. The two-dimensional (2D) layout commonly used in MRAM systems restricts the amount of memory that can be stored per unit area, leading to a higher cost per bit when compared to other memory technologies. This lower memory density poses challenges in applications that require large amounts of data storage, particularly as the demand for higher performance and reduced form factors continues to grow.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1A is a perspective view of a three-dimensional (3D) magnetoresistive random access memory (MRAM) device in accordance with some embodiments.
FIG. 1B is a cross-sectional view of the 3D MRAM of FIG. 1A device in accordance with some embodiments.
FIG. 2 is a cross-sectional view of the 3D MRAM device of FIG. 1A coupled to selector transistors and a select line in accordance with some embodiments.
FIG. 3 is a cross-sectional view of the 3D MRAM device of FIG. 1A coupled to sense amplifiers in accordance with some embodiments.
FIG. 4 is a cross-sectional view different configurations for the magnetic tunnel junction (MTJ) layers of 3D MRAM device of FIG. 1A in accordance with some embodiments.
FIG. 5 is a cross-section view of a structure after a complementary metal-oxide-semiconductor (CMOS) layer has been formed on a substrate in accordance with some embodiments.
FIG. 6 is a cross-section view of the structure after a multilayer stack of alternating sacrificial layers has been formed on the CMOS layer in accordance with some embodiments.
FIG. 7 is a cross-section view of the structure after a staircase structure has been formed in a portion of the multilayer stack of in accordance with some embodiments.
FIG. 8 is a cross-section view of the structure after an oxide layer has been formed on the staircase structure in accordance with some embodiments.
FIG. 9 is a cross-section view of the structure after trenches have been formed in the multilayer stack in accordance with some embodiments.
FIG. 10 is a cross-section view of the structure after trenches have been formed in the multilayer stack in accordance with some embodiments.
FIG. 11 is a cross-section view of the structure after vertical MTJ layers have been formed on sidewalls of the trenches, a vertical bitline has been formed in the trenches, and an isolation trench has been formed within the multilayer stack in accordance with some embodiments.
FIG. 12 is a cross-section view of the structure after a first set of sacrificial layers within the multilayer stack have been etched away to form cavities and define MTJ structures in accordance with some embodiments.
FIG. 13 is a cross-section view of the structure after insulating layers have been formed in the cavities in accordance with some embodiments.
FIG. 14 is a cross-section view of the structure after a second set of sacrificial layers within the multilayer stack have been etched to form cavities and expose the MTJ structures in accordance with some embodiments.
FIG. 15 is a cross-section view of the structure after a second wordlines have been formed in the cavities and in contact with the MTJ structures in accordance with some embodiments.
FIG. 16 is a cross-section view of the structure after a liner oxide layer has been formed on vertical sidewalls of the isolation trench in accordance with some embodiments.
FIG. 17 is a cross-section view of the structure after a stress relief fill material has been deposited within the isolation trench in accordance with some embodiments.
FIG. 18 is a cross-section view of the structure after a contact vias have been formed in the oxide layer of the staircase structure in accordance with some embodiments.
FIG. 19 is a cross-section view of the structure after electrical contacts have been formed in the vias in accordance with some embodiments.
FIG. 20 and FIG. 21 together are a flow diagram illustrating an example of an overall process for forming a 3D MRAM device in accordance with at least some embodiments.

### DETAILED DESCRIPTION

Conventional MRAM architectures typically employ a two-dimensional (2D) memory cell layout, where memory cells are arranged horizontally on a single plane. While this layout offers simplicity, it limits the overall memory density achievable in the device, leading to a tradeoff between memory capacity and physical space. As a result, scaling MRAM density in this configuration to meet the increasing demand for highcapacity storage becomes challenging and costly.

Accordingly, described herein is a three-dimensional (3D) MRAM architecture configured to increase memory density and reduce manufacturing costs while maintaining the inherent advantages of MRAM, such as relatively fast write speeds, relatively high endurance, and non-volatility. In this 3D MRAM configuration, memory cells are arranged in a vertical stack to achieve significantly higher memory density compared to traditional 3D layouts. In at least some embodiments, each memory cell includes a magnetic tunnel junction (MTJ) structure, including a pinned ferroelectric layer, an insulating tunnel barrier layer, and a free ferroelectric layer. This MTJ configuration, in at least some embodiments, is implemented using either in-plane or perpendicular configurations, providing flexibility in optimizing the memory's performance characteristics.

Note that in the following, certain orientational terms, such as top, bottom, front, back, and the like, are used in a relative sense to describe the positional relationship of various components. These terms are used with reference to the relative position of components either as shown in the corresponding figure or as used by convention in the art and are not intended to be interpreted in an absolute sense with reference to a field of gravity. Thus, for example, a surface shown in the drawing and referred to as a top surface of a component would still be properly understood as being the top surface of the component, even if, in implementation, the component was placed in an inverted position with respect to the position shown in the corresponding figure and described in this disclosure. Furthermore, certain references to major and minor surfaces should be understood as describing positional relationships relative to a primary surface of a substrate or another reference surface, and not as absolute spatial orientations. Additionally, positional terms such as co-planar or parallel will be understood to be interpreted in the context of fabrication tolerances or industry standards. For example, co-planar shall be understood to mean co-planar within applicable tolerances as a result of one or more fabrication processes affecting the components indicated to be co-planar or co-planar within a tolerance utilized in the appropriate industry or fabrication technology. Moreover, it will be appreciated that for simplicity and clarity of illustration, components shown in the figures have not necessarily been drawn to scale. For example, the dimensions of some of the components may be exaggerated relative to other components.

It should also be noted that the terms "contact", "contacts", "contacting" or their equivalents refer to instances where components, such as layers, features, or surfaces, are either in physical (direct) contact or indirect contact through one or more intermediate layers, features, or surfaces. Moreover, a component can be in "electrical contact" with one or more other components, either directly or indirectly, depending on the electrical conductivity of the intermediate material(s) between the components.

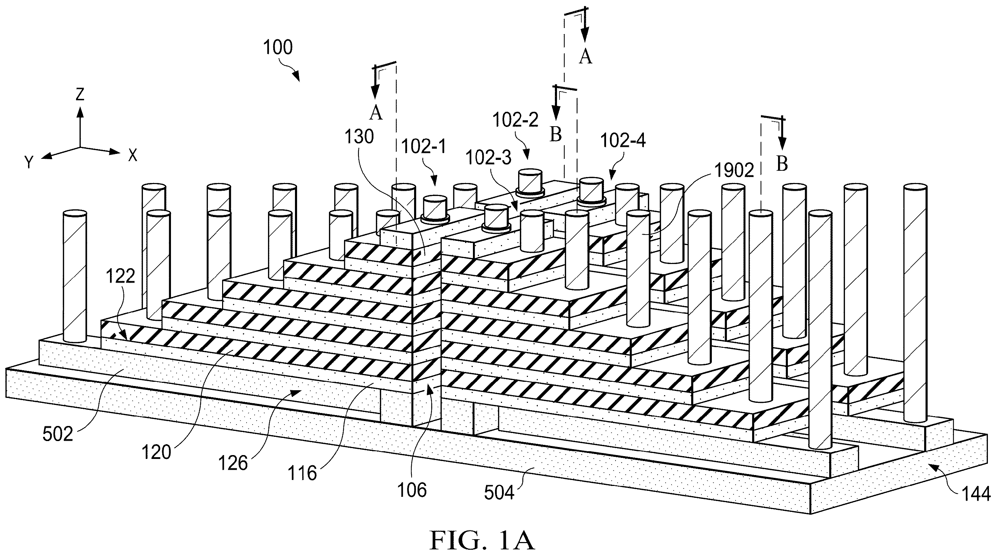

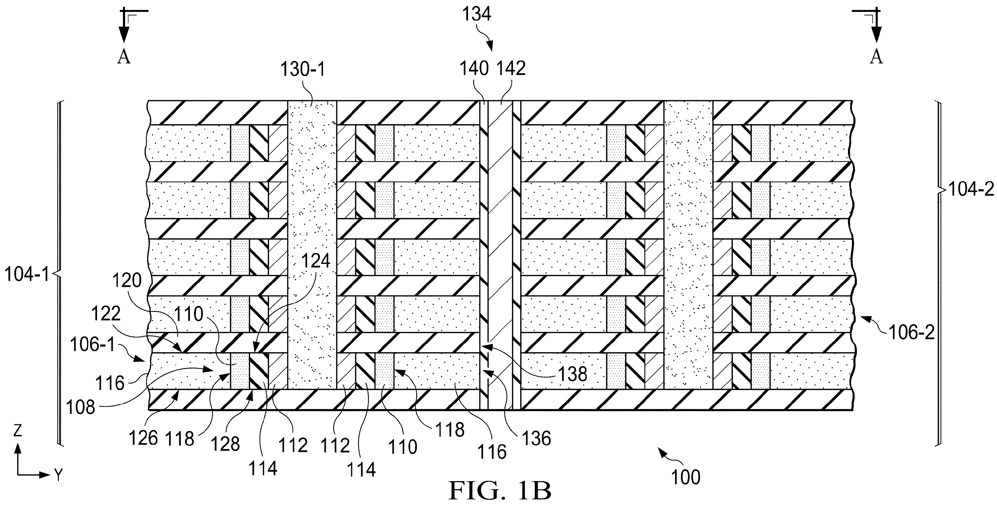

FIG. 1A and FIG. 1B illustrate an example 3D MRAM device 100. FIG. 1A is a perspective view of the 3D MRAM device 100 and FIG. 1B is a cross-sectional view of the 3D MRAM device 100 shown in FIG. 1A, taken along Line A-A. FIG. 1A and FIG. 1B are collectively referred to herein as "FIG. 1". It should be understood that certain features, layers, or components illustrated and labeled in some figures may not be shown or labeled in others to simplify the illustrations and more clearly depict underlying layers and features. Additionally, the figures are not necessarily drawn to scale, and some elements may be exaggerated or omitted to emphasize specific structural or functional details.

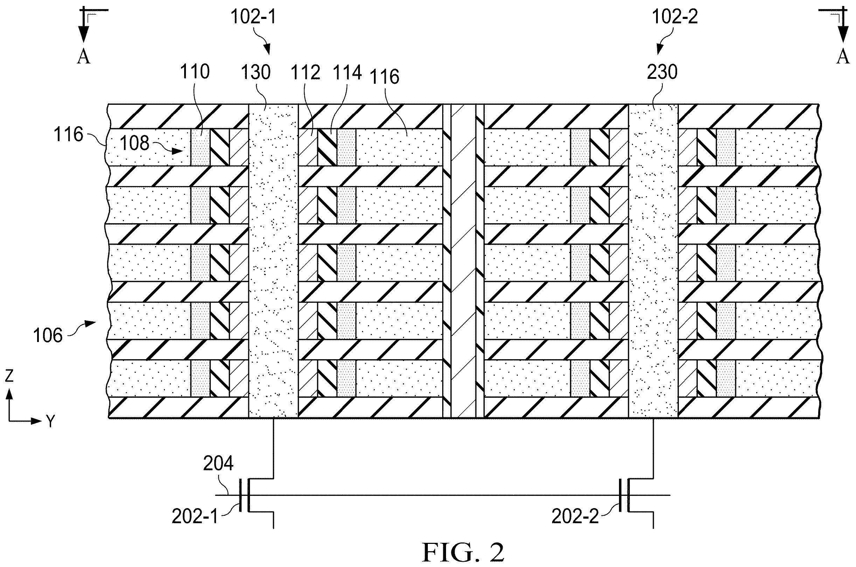

In the example illustrated in FIG. 1, the 3D MRAM device 100 is shown in a first configuration, which includes a plurality of 3D MRAM arrays 102 (illustrated as MRAM array 102-1 to MRAM array 102-4). Each MRAM array 102 includes a 3D stack 104 (illustrated as stack 104-1 and stack 104-2 in FIG. 1B) of cells 106 (illustrated as cell 106-1 and cell 106-2 in FIG. 1B) or rows. Although FIG. 1A and FIG. 1B illustrate a specific number of cells 106, other quantities of cells 106 are also applicable. For example, in FIG. 1, five cells 106 are shown in 3D stack 104-1 and five cells 106 in 3D stack 104-2. However, in other configurations, each of the 3D stacks 104 may include more or fewer cells. Also, for ease of illustration and readability, the features of a single cell 106 in one of the 3D stacks 104 will be described. It should be understood, however, that this description also applies to the other cells 106 within the 3D stack 104 and to each cell 106 in the other 3D stacks 104. Also, for clarity in the figures, identical features of different cells 106 may be referenced in separate instances across different figures. For example, a reference number for a specific feature may be shown in one cell in FIG. 1 and in another cell in FIG. 2, even though the feature is present in every cell 106 throughout the structure.

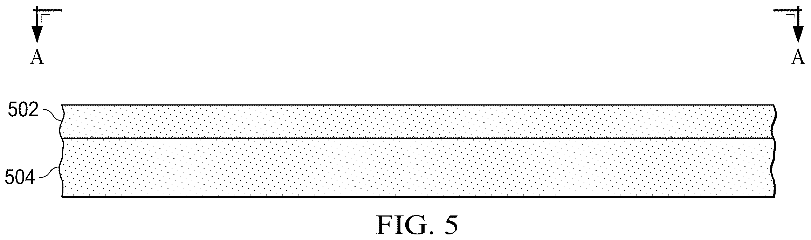

The cells 106 of one MRAM array 102 are stacked on top of each other in the z-direction as depicted in FIG. 1A and 1B, and which is generally perpendicular to the major surface 144 of the substrate 504 (FIG. 1A and FIG. 5). Each stacked cell 106 includes a magnetic tunnel junction (MTJ) 108 (not shown in FIG. 1A). In the views shown in FIG. 1, the MTJs 108 are stacked on each other in the z-axis direction (e.g., the vertical direction as depicted in FIG. 1). Stated differently, the MTJs 108 are stacked on top of each other in the z-direction, and which is generally perpendicular to the major surface 144 of the substrate 504. Each MTJ 108 (also referred to herein as "MTJ structures 108") in the 3D stack 104 includes a plurality of layers, including a first magnetic layer, such as a free layer 110 and a second magnetic layer, such as a pinned layer 112 (or reference layer), which are separated by an insulating layer, such as a tunnel barrier 114, disposed between the first magnetic layer and the second magnetic layer. The free layer 110, pinned layer 112, and tunnel barrier 114 are not shown in FIG. 1A. In at least some embodiments, the free layer 110 and the pinned layer 112 comprise magnetic materials, such as cobalt (Co), iron (Fe), boron (B), CoFeB alloys, Co/platinum (Pt) multilayers, Co/nickel (Ni) multilayers, other ferromagnetic multilayer materials, alloys with transition metals or rare earth metals, or any combination thereof. In at least some embodiments, the tunnel barrier 114, which provides for quantum tunneling, is composed of one or more materials, such as magnesium oxide (MgO), aluminum oxide (AlO), or similar insulating materials. Additional insulating or barrier layers (not shown) may also be included in the MTJ structure 108.

In at least some configurations, the pinned layer 112 layer has a fixed magnetization state with a high level of magnetization and remains stable during operation, serving as a point of comparison for the free layer 110. The free layer 110 has a variable magnetization state, meaning it is not pinned or fixed like the reference layer, and has a lower amount of magnetization, allowing its magnetic orientation to rotate freely in response to external magnetic fields. Depending on the operational state, the magnetization of the free layer 110 can align either parallel or anti-parallel to the pinned layer 112. When the magnetizations of the free layer 110 and the pinned layer 112 are parallel, electrons are able to tunnel through the tunnel barrier 114, resulting in low resistance. In contrast, when the magnetizations are anti-parallel, tunneling is inhibited, leading to high resistance. This change in resistance allows the MTJ 108 to store and represent binary data (0 or 1).

The magnetization of the free layer 110, in at least some embodiments, is controlled in different ways. One method involves passing a current through an adjacent copper line to generate a magnetic field that influences the free layer 110. Another method involves directly injecting a spin-polarized current into the MTJ 108, creating a torque that rotates the magnetic orientation of the free layer 110. These mechanisms enable switching between the parallel and anti-parallel states, facilitating the read and write operations of the MRAM device 100.

As depicted in FIG. 1B, rather than being stacked in the vertical (z-direction) orientation in the cross-sectional view, the free layer 110, the pinned layer 112, and the tunnel barrier 114 are arranged adjacent to each other in the horizontal direction, that is, the y-direction as depicted in FIG. 1A and FIG. 1B, forming a lateral MTJ structure 108. In at least some embodiments, the MTJ layers 108 have major surfaces (e.g., top surface 124 and bottom surface 128) that are parallel with each other and are oriented perpendicular with a major surface 144 of the substrate 504 in the x-direction. This lateral arrangement optimizes the layout for 3D MRAM by enabling more efficient routing of bitlines (BL) and wordlines (WL), which improves memory density and minimizes interference between neighboring cells. Additionally, this configuration enhances scalability while addressing the lithographic challenges associated with vertical stacking. In at least some embodiments, the top surfaces 124 of the MTJ layers (the free layer 110, the tunnel barrier 114, and the pinned layer 112) are co-planar.

In at least some embodiments, each cell 106 has either an in-plane MTJ configuration or a perpendicular MTJ configuration. In the in-plane MTJ configuration, the magnetization of both the free layer 110 and the pinned layer 112 layer lies parallel to the plane of the layers. The magnetic moments switch between parallel and antiparallel states within this plane. When the magnetization directions are aligned parallel, the MTJ 108 is in its low resistance state due to efficient electron tunneling through the insulating layer, resulting in lower electrical resistance. Conversely, when the magnetization is antiparallel, the MTJ 108 enters a high resistance state, where electron tunneling is less efficient because of the misalignment of the magnetic moments, leading to increased resistance.

In contrast, the perpendicular MTJ configuration has magnetization orientations that are perpendicular to the plane of the layers. In this configuration, the MTJ 108 achieves a low resistance state when the magnetization directions of the free layer 110 and the pinned layer 112 are aligned perpendicularly in the same direction, facilitating easier electron tunneling. The high resistance state occurs when the magnetization of the free layer 110 is opposite to that of the pinned layer 112, hindering electron tunneling due to the antiparallel alignment of the magnetic moments. Both in-plane and perpendicular MTJ configurations operate based on the principle of tunneling magnetoresistance (TMR), where the relative orientation of the magnetic moments in the free and pinned layers determines the electrical resistance of the MTJ 108.

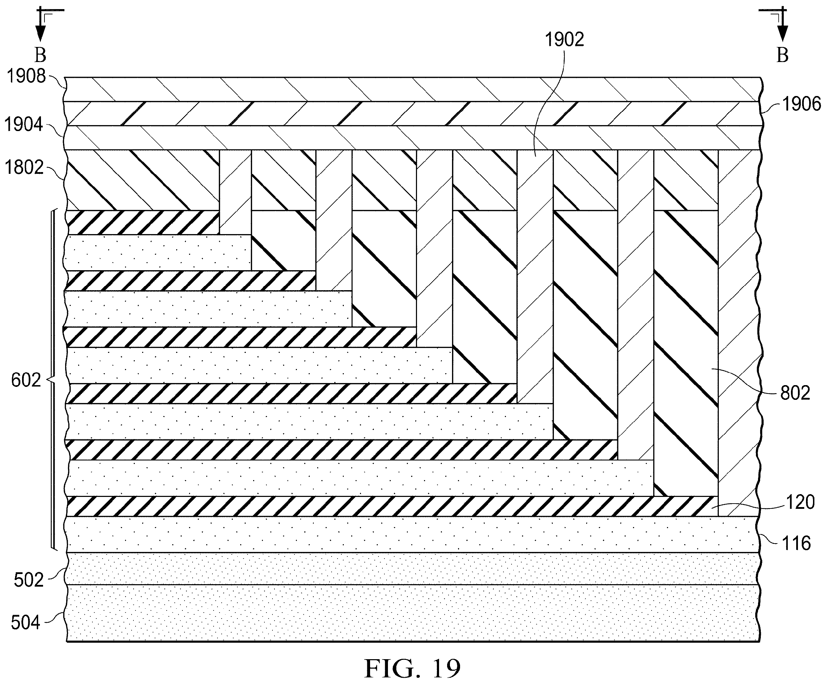

Each MTJ 108 in the 3D stack 104 is associated with a first interconnect structure of a first type, such as a wordline (WL) connector 116. In the example shown in FIG. 1, each wordline connector 116 (e.g., a contact) is a horizontal connector that runs in the x-direction and y-direction relative to the views depicted in FIG. 1. In at least some embodiments, each wordline connector 116 is electrically connected to an access line, such as a wordline, through a vertical contact (e.g., contact 1902 in FIG. 19) that interfaces with the metal routing layers (e.g., M1 layer 1904, M2 layer 1906, and M3 layer 1908 in FIG. 19). The wordline itself, in at least some embodiments, is a horizontal conductor in one of these metal layers, which delivers signals from a driving circuit to the wordline connector 116.

In at least some embodiments, each cell 106 has a separate wordline connector 116 that does not intersect with any other cell 106 of any other MRAM array 102. The wordline connector 116 is positioned adjacent to the free layer 110 in the view depicted in FIG. 1 and makes contact with the end or terminal surface 118 (not shown in FIG. 1A) of the free layer 110, which is opposite the surface in contact with the tunnel barrier 114 of the MTJ 108. This direct contact between the wordline connector 116 and the terminal surface 118 of the free layer 110 enables efficient transmission of electrical signals, allowing for precise control of the MTJ 108 during read and write operations. In the configuration shown in FIG. 1, the wordline connector 116 acts as an access interconnect for selecting or accessing the associated cell 106.

In this context, "horizontal" refers to the arrangement of the wordline connectors 116 along the sides of the MTJs 108 in the x-axis and y-axis of the views illustrated in FIG. 1, where the MTJs 108 are stacked vertically along the z-axis. However, it should be understood that the terms "horizontal" and "vertical" are relative to the depicted orientation. Regardless of the physical orientation of the device, the wordline connectors 116 are consistently arranged along the sides of the MTJs 108 in the horizontal (x-axis) and depth (y-axis) directions relative to the 3D stack 104.

This lateral arrangement of the wordline connectors 116, combined with the wordlines routed in the metal layers and their vertical contacts, allows each MTJ 108 within the 3D stack 104 to be selectively controlled during read and write operations. Also, the wordline connectors 116, due to their lateral placement and material properties, ensure that the 3D MRAM structure maintains a high level of scalability while reducing interference between adjacent cells. This efficient routing system improves the device's ability to handle large volumes of data at high speeds, making it suitable for modern memory applications requiring high density and performance. In at least some embodiments, the wordline connectors 116 are composed of conductive materials, such as tungsten (W), copper (Cu), aluminum (Al), and the like.

Additionally, the wordline connector 116 is connected to an access transistor (not shown in FIG. 1) via the wordline routed in the metal layers (e.g., M1 layer 1904, M2 layer 1906, M3 layer 1908). This connection is established through contact(s) 1902 or traces forming the wordline, which electrically link the wordline connector 116 to the gate of the access transistor. The access transistor acts as a switch, allowing the wordline, via the wordline connector 116, to selectively enable or disable the current flow through the MTJ 108, facilitating precise access to individual cells 106 during operations.

The 3D MRAM device 100 also includes a plurality of stacked insulating layers 120. Each cell 106 of MTJs 108 and their associated wordline connectors 116 is separated from each other in the z-direction (e.g., the vertical direction in the views depicted in FIG. 1) by an insulating layer 120 of the plurality of stacked insulating layers 120, which provides electrical isolation between the vertically stacked cells 106 within the 3D stack 104. In an at least some embodiments, the insulating layer 120 includes one or more materials, such as silicon dioxide (SiO₂) or silicon nitride (Si₃N₄) and serves both as an electrical insulator and as structural separation between the cells 106 of stacked MTJs 108. The insulation ensures that electrical signals applied to one wordline connector 116 and its associated MTJs 108 do not interfere with the MTJs 108 in adjacent stacks located above or below, allowing precise control over each MTJ 108 within the 3D stack 104.

In the views shown in FIG. 1, the insulating layer 120 contacts the top surface 122 of a wordline connector 116 and the top surface 124 (not shown in FIG. 1A) of each layer of the MTJ 108 in an underlying cell 106 of the 3D stack 104, and also contacts the bottom surface 126 of a wordline connector 116 and the bottom surface 128 of the MTJ 108 in an overlying cell 106. These references to "top" and "bottom" surfaces are relative to the depicted orientation of FIG. 1. However, if the MRAM device 100 is rotated, the insulating layer 120 continues to function in the same manner by contacting the surfaces of wordline connectors 116 and MTJs 108 that are positioned between adjacent cells 106, whether they are above, below, or laterally positioned. In any orientation, the insulating layer 120 ensures electrical isolation between cells 106 of MTJs 108 and wordline connectors 116, preventing unwanted electrical signals from crossing between adjacent cells 106.

Furthermore, the insulating layer 120 supports the scalability of the 3D MRAM architecture, allowing for efficient vertical stacking of MTJs 108 and wordline connectors 116 while minimizing interference between layers. In at least some embodiments, the insulating layer 120 also functions as a thermal barrier, helping to mitigate heat transfer between stacked layers and improving the durability and longevity of the MRAM device 100.

Each MRAM array 102 is associated with a second interconnect structure of a second type, such as a bitline (BL) 130 or another access line, that runs in the z-direction (e.g., vertically) relative to the orientations depicted in FIG. 1 and, in at least some embodiments, is oriented orthogonal to the wordline connectors 116. The bitlines 130 extend through the stacked cells 106, and contact the pinned layer 112 and insulating layer 120. In at least some embodiments, the free layer 110, the pinner layer 112, and the tunnel barrier 114 of the MTJs 108 in an MRAM array 102 surround the corresponding bitline 130. The bitlines 130, in at least some embodiments, are composed of conductive metals, such as copper (Cu) or aluminum (Al), that have low electrical resistance and the ability to carry the high-speed currents required for memory access. In at least some embodiments, a diffusion barrier layer (not shown) made from materials such as tantalum (Ta) or titanium nitride (TiN) surrounds the bitline 130 to prevent metal diffusion into surrounding layers, maintaining the integrity of the MRAM array 102. Each bitline 130, in at least some embodiments, is configured to interface with, directly interface with, or directly contact a sidewall 132 of each pinned layer 112 in the MRAM array 102.

In the configuration shown in FIG. 1, the bitline 130 provides the electrical pathway required for accessing the MTJs 108 within the stack 104 for both read and write operations. The bitline 130 is responsible for supplying the current necessary for spin transfer torque (STT) operations in the MTJ 108, which enables the free layer 110 to switch its magnetic orientation between parallel and anti-parallel states. During write operations, the wordline connector 116 is activated to select the specific row of MTJs. A current is then driven from the bitline 130 through the MTJ 108, starting from the pinned layer 112, passing through the tunnel barrier 114, and affecting the free layer 110. This current flow induces the STT effect, changing the orientation of the free layer 110. During read operations, a smaller sensing current flows from the bitline 130 through the MTJ 108 to the wordline connector 116. This current allows the system to measure the resistance state of the MTJ 108 to determine the stored data.

In the configuration shown in FIG. 1, the bitline 130 acts as the bottom electrode, connecting to the pinned layer 112 of each MTJ 108 in the stack 104. In at least some embodiments, the wordline connector 116 acts as the top electrode and is configured to interface with, directly interface with, or directly contact the free layer 110 of the MTJ 108, providing the current path during read and write operations. In the view shown in FIG. 1, the bitline 130 facilitates both the writing and reading of data in conjunction with the selected wordline connector 116, which allows the current to flow through the MTJ 108 to STT for writing or to sense the resistance state for reading. As such, in the configuration shown in FIG. 1, the bitline 130 acts as a signal interconnect by providing a pathway for both writing data to the cells 106 and reading data from the cells 106.

In at least some embodiments, an isolation layer 134 (not shown in FIG. 1A) is positioned or disposed between adjacent MRAM cells 102. This isolation layer 134 electrically separates the bitlines 130 of neighboring MRAM cells 106, preventing unwanted electrical interference and crosstalk that could otherwise degrade the performance of the memory array. In this configuration, the isolation layer 134 contacts end surfaces 136 (not shown in FIG. 1A) of the wordline connectors 116 and end surfaces 138 (not shown in FIG. 1A) of the insulating layer 120 that are adjacent to neighboring bitlines 130, forming an insulating barrier that separates them electrically. The isolation layer 134 ensures electrical isolation between adjacent bitlines 130, reducing the risk of leakage currents or interference that could affect the read and write operations of the MRAM cells 106. Regardless of the orientation of the MRAM device 100, the isolation layer 134 functions to insulate bitlines 130 that are laterally positioned next to each other within the 3D stack 104.

In at least some embodiments, the isolation layer 134 includes a liner oxide layer 140 in contact with the end surfaces 136 of the wordline connectors 116 and the end surfaces 138 of the insulating layer 120. The liner oxide layer 140, in at least some embodiments, includes dielectric materials, such as silicon oxide (SiO₂) or silicon nitride (Si₃N₄). These materials effectively block electrical signals from propagating between neighboring bitlines 130, ensuring that signals remain confined to the selected bitline during read and write operations. The isolation layer 134, in at least some embodiments, also includes a stress relief fill material 142 between the inner sidewall of the liner oxide layer 140. The stress relief fill material 142 compensates for stress and prevent wafer warpage. In at least some embodiments, the stress relief fill material 142 includes trench filling materials, such as metal (e.g., tungsten, titanium nitride, a combination thereof, and the like) or polysilicon, are used. These materials are deposited into the trench areas around the bitlines 130 and the isolation layer 134 to relieve mechanical stress, maintaining the structural integrity of the memory array.

In at least some embodiments, to ensure precise writing and prevent sneak currents, a selector transistor 202 (illustrated as transistor 202-1 and 202-2) is connected to each MRAM array 102, acting as a bitline selector, as shown in FIG. 2. The gate of this transistor 202 is controlled by a select line (SL) 204, which manages whether the bitline 130, 230 is connected to ground. During a write operation, a specific cell 106 is selected for writing by applying a turn-on voltage (Von) to the select line (SL) 204 associated with the desired MRAM array 102. This activates the selector transistor 202, grounding the corresponding bitline 130, 230. By grounding the bitline 130, 230, a current path is established through the MTJ 108 of the selected cell 106. Simultaneously, a write voltage (Vw) is applied to the wordline connector 116 of the selected cell 106. This voltage is sufficient to generate the current needed to induce the STT effect, allowing the free layer 110 to switch its magnetic orientation between parallel and antiparallel states relative to the pinned layer 112.

A reduced voltage of Vw/2, in at least some embodiments, is applied to all unselected wordline connectors 116 to prevent unintentional writing to other cells 106 in the MRAM array 102. This reduced voltage is carefully calibrated to be insufficient to cause any magnetization change in the first magnetic layers 110 of these unselected cells 106, thereby avoiding accidental writes. Furthermore, unselected select lines 204 are set to float (F), effectively isolating their corresponding bitlines 130, 230 and preventing any sneak currents.

During the write operation, the current flows from the wordline connector 116 through the MTJ 108 of the selected cell 106, starting at the free layer 110, passing through the tunnel barrier 114, and entering the pinned layer 112. The current then exits into the grounded bitline 130. The flow of this current through the MTJ 108 generates the necessary spin-transfer torque to change the magnetization state of the free layer, effectively writing the desired data bit into the selected MRAM cell 106. By managing these voltage levels (Von for selecting the bitline, Vw for writing, Vw/2 for unselected wordlines, and floating unselected select lines), the write operation is precisely targeted, ensuring reliable data storage in the MRAM array 102 while avoiding unintentional changes in other cells 106.

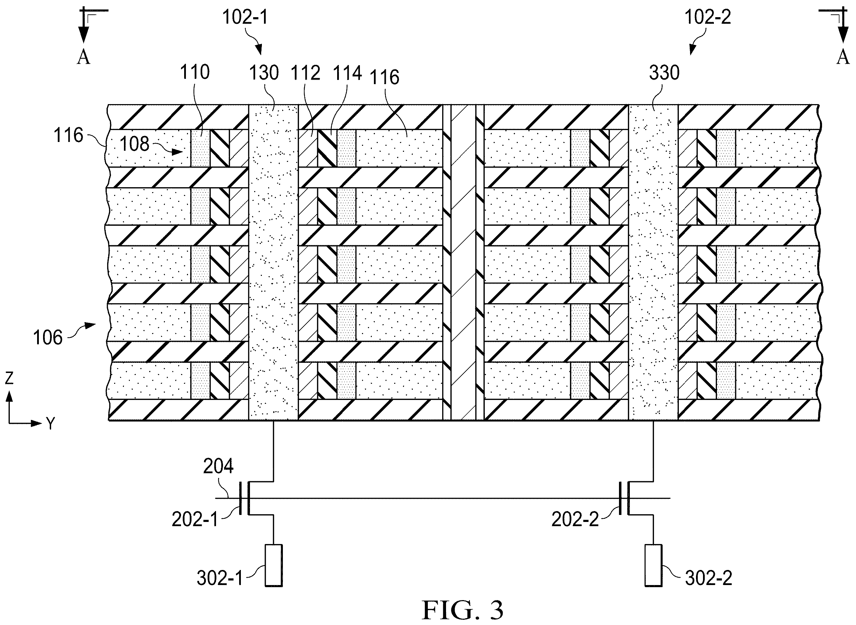

During a read operation, a cell 106 is selected within the MRAM arrays 102 by applying a read voltage (Vr) to the wordline connector 116 of the selected cell 106. The application of Vr ensures that the correct cell 106 is addressed for reading, creating a current path through the MTJ 108 in the cell 106. The select line 204 that controls the MRAM array 102 with the selected cell 106 is turned on. This action activates the selector transistor 202, connecting the corresponding bitline 130, 330 to sense amplifiers 302 (illustrated as sense amplifier 302-1 and sense amplifier 302-2) and allowing the current to flow through the MTJ 108 of the selected cell 106, as shown in FIG. 3.

The current flows from the wordline connector 116 into the free layer 110 of the MTJ 108 in the selected cell 106, passes through the tunnel barrier 114, and enters the pinned layer 112. The current then exits through the bitline 130, 330, which is connected to the sense amplifier 402. This current flow is carefully controlled to ensure it is small enough to sense the resistance state of the MTJ 108 without altering the magnetization state of the free layer 110, thereby preserving the stored data.

The sense amplifier 302 detects the resistance of the MTJ 108 in the selected cell 106 by measuring the voltage drop as the current passes through. The resistance state indicates the data stored in the cell 106, with a lower resistance representing a parallel alignment of the free layer 110 and the pinned layer 112 (indicating one binary state) and a higher resistance indicating an antiparallel alignment (indicating the opposite binary state). By applying the read voltage (Vr) to the selected wordline connector 116 and turning on the select line 204 to activate the selector transistor 202 and connect the bitline 130, 330 to the sense amplifier 302, the data of the selected cell 106 is read out. This coordinated process ensures that the selected cell 106 is accurately accessed, and the data is retrieved efficiently from the MRAM array 102.

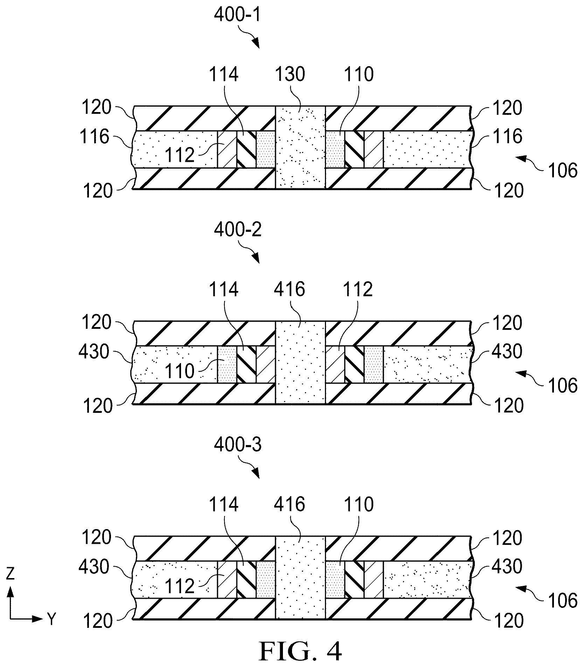

It should be understood that other configurations of the MTJ structure 108, wordline connectors 116, and bitlines 130 are applicable as well. For example, FIG. 4 shows additional configurations 400 (illustrated as configuration 400-1 to configurations 400-3) of these components in an MRAM cell 106 . In a second configuration 400-1, the positions of the free layer 110 and the pinned layer 112 are swapped such that the free layer 110 is now the innermost layer (the layer closest to the bitline 130) of the MTJ 108 and the pinned layer 112 is now the outermost layer (the layer farthest from the bitline 130). In the view illustrated in FIG. 4, the wordline connector 116 runs in the x-direction similar to the configuration described above with respect to FIG. 1.

In this configuration, the bitline 130 still provides the electrical pathway for accessing the MTJs 108 for read and write operations, but the roles of the layers are reversed. The bitline 130 is now connected to the free layer 110. During write operations, the current is supplied starting from the bitline 130, passing through the free layer 110, the tunnel barrier 114, and the pinned layer 112, and then exiting through the wordline connector 116. This reversal in the current path changes the way the spin-transfer torque (STT) effect interacts with the free layer 110, as the current flow now originates from the bitline connected to the free layer 110 and travels towards the pinned layer 112. During read operations, the bitline 130 supplies a sensing current that flows through the MTJ 108 in the same manner, starting from the free layer 110 and passing through the pinned layer 112 to the wordline connector 116. This allows the system to measure the resistance state of the MTJ 108 to determine the stored data.

The bitline 130 still acts as the bottom electrode, but in this configuration, it connects to the free layer 110. The wordline connector 116 now interfaces with the pinned layer 112 and acts as the top electrode. Unlike the configuration illustrated in FIG. 1, the wordline connector 116 facilitates the exit path for the current through the pinned layer 112 during both read and write operations. This reversal means that the current enters through the bitline 130 connected to the free layer 110 and exits through the wordline connector 116 after passing through the MTJ 108, thereby completing the circuit.

In a third configuration 400-2, the positions of the free layer 110 and the pinned layer 112 remain the same as in FIG. 1, but the physical orientations of the wordline connector 116 and what was previously referred to as the bitline 130 are reversed. As such, in this configuration, what was previously designated as the wordline connector 116 and bitline 130 are now designated as the wordline 416 and bitline connectors 430, reflecting their changed placement and role within the MRAM array 102. For example, each cell 106 now includes a separate bitline connector 430 arranged horizontally (along the x- and y- directions) that contacts the terminal ends of the pinned layer 112. Unlike a continuous bitline running across multiple cells, each bitline connector 430 interfaces with one or more metal routing layers (e.g., M1 layer 1904, M2 layer 1906, and M3 layer 1908 in FIG. 19) through vertical vias (not shown in FIG. 4). These vias ensure proper signal routing and electrical functionality.

During write operations, the bitline connector 430 supplies the necessary current that flows through the MTJ 108 of the selected cell 106. The current travels from the bitline connector 430, into the free layer 110, passing through the tunnel barrier 114, to the pinned layer 112, and finally exiting through the vertical wordline 416. As the current passes through the pinned layer 112, it becomes spin-polarized, enabling the spin-transfer torque (STT) effect to switch the magnetic orientation of the free layer 110. During read operations, the bitline connector 430 supplies a sensing current that follows the same path, starting at the free layer 110, traversing the tunnel barrier 114 to the pinned layer 112, and exiting through the wordline 416. The sensing current allows for determination of the MTJ's resistance state, and thus the stored data.

In this configuration, the bitline connector 430 acts as the electrode connected to the free layer 110, while the vertical wordline 416 serves as the electrode interfacing with the pinned layer 112. This arrangement changes how current interacts with the MTJ structure while still allowing for effective MRAM operation. Each cell 106 now has its own dedicated bitline connector 430 leading to metal routing layers, ensuring isolation and scalability, and facilitating targeted read/write operations within the 3D MRAM array 102.

In a fourth configuration 400-3, the positions of the free layer 110 and the pinned layer 112 are the same as in the second configuration 400-1, and the relative orientations of the wordline and bitline structures follow those in the third configuration 400-2. For example, in each cell 106, the free layer 110 is now the innermost layer (the layer closest to the center of the cell 206) of the MTJ 108 and the pinned layer 112 is now the outermost layer (the layer farthest from the center of the cell 206). Also, each cell 106 now includes a bitline connector 430 that is a horizontal interconnect (running in the xand y-directions) and that makes contact with the terminal ends of the free layer 110. Unlike a continuous bitline shared among multiple cells, each cell's bitline connector 430 interfaces individually with the free layer 110 and connects to metal routing layers (e.g., M1 layer 1904, M2 layer 1906, and M3 layer 1908 in FIG. 19 through vertical vias (not shown in FIG. 4). Additionally, the MRAM array 102 now includes a vertical wordline 416 that extends in the z-direction, contacting the free layer 110 and the insulating layers 120. Thus, in this configuration, the pinned layer 112 is accessed via a horizontal bitline connector 130, while the free layer 110 is accessed via the wordline 416.

During write operations, the bitline connector 430 supplies the current that flows through the MTJ 108. The current enters the MTJ 108 at the pinned layer 112, passes through the tunnel barrier 114, and then reaches the free layer 110 before exiting through the wordline 416. As the current flows from the pinned layer 112 to the free layer 110, it becomes spin-polarized due to the fixed magnetic orientation of the pinned layer 112, enabling the spin-transfer torque (STT) effect to switch the magnetic orientation of the free layer 110. During read operations, the bitline connector 430 again provides the sensing current that follows the same path, e.g., beginning at the pinned layer 112, traversing the tunnel barrier 114 to the free layer 110, and exiting through the wordline 416. By measuring the MTJ's resistance, the stored data can be determined.

In this fourth configuration 400-3, the bitline connector 430 serves as the electrode connected to the pinned layer 112, while the wordline 416 interfaces with the free layer 110, acting as the electrode through which current exits the MTJ 108. Thus, the current enters the MTJ 108 from the pinned layer 112 side (via the bitline connector 430) and exits from the free layer 110 side (via the wordline 416). In contrast, in the third configuration 400-2, the bitline connector 430 is connected to the free layer 110, causing the current to first interact with the free layer 110 before reaching the pinned layer 112. By reversing the positions of the free and pinned layers for the fourth configuration 400-3, the current now flows from the pinned layer 112 toward the free layer 110. Despite these changes, both configurations enable proper MRAM operation. The wordline 116 remains a common exit path for current, while the dedicated bitline connector 430 in each cell supplies the entry current to the MTJ 108.

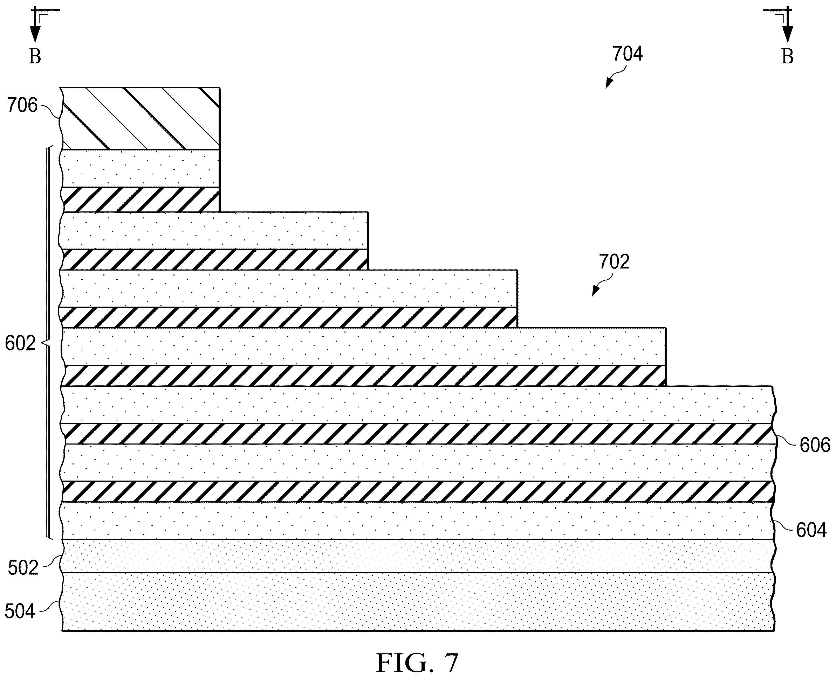

FIG. 5 to FIG. 19 illustrate various processes for fabricating 3D MRAM devices 100 in accordance with one or more embodiments. FIGS. 5, 6, and 9-17 show a cross-section of the MRAM device 100 taken along line A-A in FIG. 1A, while FIGS. 7, 8, 18, and 19 show a cross-section of the MRAM device 100 taken along line B-B in FIG. 1A. It should be understood that the number of layers and features depicted in FIGS. 5 through 19 may differ from those shown in FIGS. 1 through 4 for purposes of clarity and illustration. In at least some embodiments, the fabrication process begins with the formation of complementary metal-oxide-semiconductor (CMOS) layer 502 (also shown in FIG. 1A) on a silicon substrate 504 (also shown in FIG. 1A), as shown in FIG. 5. The CMOS layer 502 serves as the foundational layer for the 3D MRAM device 100. The CMOS layer 502 includes the necessary logic and control circuitry to manage the MRAM operations, including data read, write, and addressing functions.

In at least some embodiments, the CMOS layer 502 is formed using a series of photolithography, doping, and deposition processes. The process starts with the silicon substrate 504 being cleaned and prepared using a series of chemical treatments to remove any surface contaminants. A thin layer of silicon dioxide (SiO₂) is then grown on the wafer surface through thermal oxidation. This oxide layer acts as an initial gate dielectric for the MOS transistors. Next, a photolithography process is used to pattern the silicon substrate 504. A photoresist layer is applied, and ultraviolet (UV) light is used to expose specific regions of the wafer through a mask, transferring the circuit pattern. After exposure, the photoresist is developed, leaving behind a patterned layer that protects certain areas of the wafer during subsequent etching steps. Reactive ion etching (RIE) is used to remove the unprotected silicon dioxide and define the active areas where transistors will be formed.

Ion implantation is then performed to introduce dopants into the silicon substrate 504, creating n-type and p-type regions that form the source and drain terminals of the MOS transistors. The implanted ions are driven into the substrate using thermal annealing, activating the dopants and repairing any lattice damage caused during implantation. After the formation of the source and drain regions, the gate structures (not shown) are created. A thin gate oxide layer is grown over the transistor channel regions, followed by the deposition of a polysilicon layer. This polysilicon layer is then patterned using a second photolithography step to form the transistor gates (not shown).

Interconnect layers are subsequently formed to connect the various transistors and other circuit elements. This involves the deposition of an interlayer dielectric (ILD) material, typically silicon dioxide, followed by the creation of vias and trenches through photolithography and etching processes. Metal layers, such as copper or tungsten, are then deposited using physical vapor deposition (PVD) or chemical vapor deposition (CVD) techniques to fill these vias and trenches, forming the interconnects. Chemical mechanical planarization (CMP) is used to form a planar surface for subsequent processing steps.

The CMOS formation process results in a layer 502 at the base of the MRAM array 102, including the circuitry needed for control and addressing of the MRAM cells 106. This configuration, known as CMOS under array (CUA), integrates the CMOS circuitry directly beneath the MRAM array 102. CUA reduces the area consumed by access circuitry, allowing for a more compact and efficient layout. This arrangement optimizes the use of space by placing the control circuitry directly under the MRAM cells 106, enhancing overall device density without compromising performance..

It should be understood that other processes for forming the CMOS layer 502 are applicable as well. For example, a CMOS next-to-array (CNA) configuration can be implemented, which places the CMOS access circuitry adjacent to the MRAM array 102 rather than beneath it. In another example, a CMOS Bonded Array (CBA) configuration can be implemented. In this configuration, the CMOS logic is processed and formed on a separate wafer, which is then bonded to the MRAM wafer.

Following the formation of the CMOS layer 502, a multilayer stack 602 of alternating sacrificial layers 604, 606 is formed on the CMOS layer 502. In at least some embodiments, the stack 602 is formed by depositing a first layer of sacrificial material, such as silicon dioxide, onto the CMOS layer 502 to form a first sacrificial layer 604. This silicon dioxide layer is deposited using, for example, a CVD process. In this process, a silicon-containing precursor, such as tetraethyl orthosilicate (TEOS), is introduced into a reaction chamber along with an oxidizing agent, such as oxygen (O₂). The precursor decomposes at high temperatures (e.g., approximately 400-500°C) to form a conformal layer of silicon dioxide on the surface of the CMOS layer 502. The thickness of this silicon dioxide layer can be controlled precisely by adjusting the deposition time and the flow rates of the precursor gases.

After the first sacrificial layer 604 is deposited, another layer of insulating material, such as silicon nitride, is deposited on top of the first sacrificial layer 604 to form a second sacrificial layer 606. The second sacrificial layer 606 is deposited using, for example, a low-pressure chemical vapor deposition (LPCVD) process. In LPCVD, silane (SiH₄) and ammonia (NH₃) gases are introduced into the reaction chamber, where they react at elevated temperatures (e.g., approximately 700-800°C) to form a silicon nitride film. The process of alternating sacrificial material and insulating material deposition is repeated to form multiple layers in the stack 602.

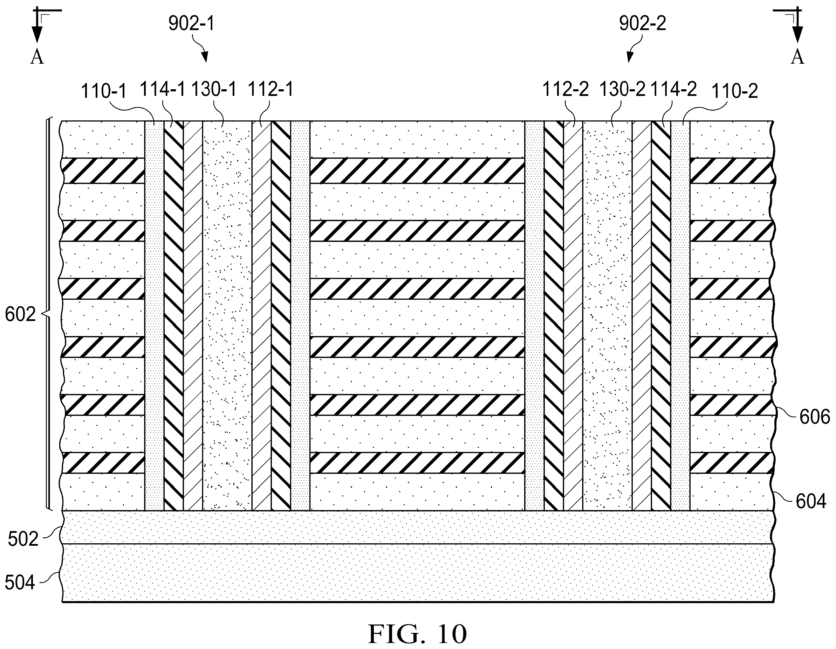

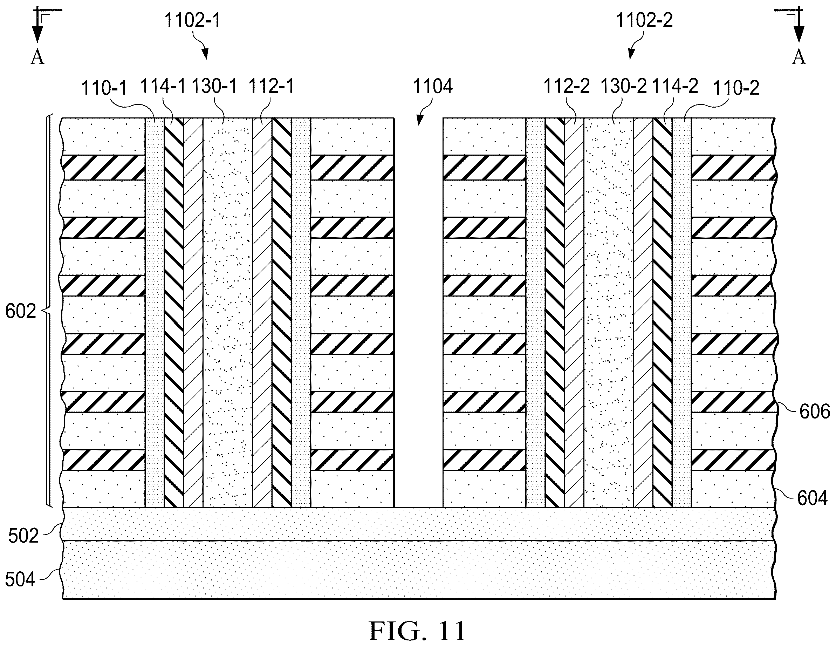

FIG. 7 shows that after the stack 602 of alternating sacrificial layers 604, 606 and is formed, a staircase structure 702 is formed in a different portion 704 of the stack 602. However, in other embodiments, the staircase structure 702 is formed at a later stage, such as after the formation of the vertical bitline 130 in FIG. 10 and before the formation of the isolation trench 1104 in FIG. 11 (e.g., a "staircase last" process). In these embodiments, the staircase is formed by selectively etching through the multilayer stack 602 after the bitline 130 is in place, ensuring that the staircase aligns with the vertical bitline connections.

The purpose of the staircase structure 702 is to provide a connection path from the underlying peripheral circuits to layers of the MRAM device 100. This selective staircase formation involves partially removing the multilayer stack 602 to enable subsequent metallization. In at least some embodiments, the staircase structure 702 is formed by applying a photoresist layer 706 over the entire stack 602. Photolithography is then used to pattern the photoresist in the region where the first step of the staircase structure 702 will be formed. A photomask defines the area to be etched, and UV light exposure through this mask alters the photoresist's properties in the designated regions. After development, the patterned photoresist reveals the specific section of the stack 602 to be etched for the first step.

In at least some embodiments, RIE is employed to remove the exposed portion of the stack 602, forming the initial step of the staircase structure 702. During RIE, reactive gases, such as carbon tetrafluoride (CF₄) or sulfur hexafluoride (SF₆), create a plasma that etches away the exposed layers of the stack 602, stopping at a controlled depth. After the first step is formed, a photoresist trimming process is performed to reduce the dimensions of the existing photoresist 706, thereby exposing an additional area of the stack 602 for the next etching step. Another round of RIE is then performed, forming the next step of the staircase structure 702. This process of photoresist trimming and subsequent RIE etching is repeated for each step, progressively exposing more layers of the stack 602. Each cycle reduces the size of the photoresist 706, allowing the staircase pattern to be formed iteratively until the complete staircase structure 702 is created, with each step providing a flat landing area for future electrical contacts.

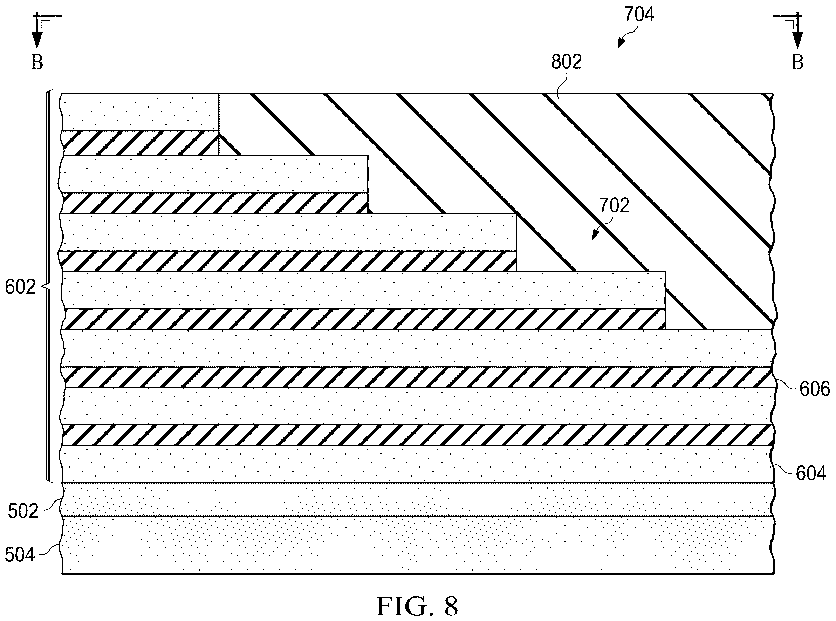

After the final step is formed, the staircase structure 702 is ready formation of an oxide layer 802 and planarization, as shown in FIG. 8. The oxide layer 802 serves to further define the staircase structure 702 and ensures proper isolation and the creation of a flat surface for the subsequent processing steps. In at least some embodiments, a material, such as silicon dioxide, is deposited over the entire stack 602, covering both the newly formed staircase structure 702 and the area where the MTJ layers 108 will be later formed. This oxide deposition is again carried out using, for example, a CVD process. During CVD, a silicon precursor gas, such as TEOS, reacts with an oxidizing agent in the chamber, depositing a uniform silicon dioxide layer across the surface. This layer 802 fills any remaining gaps in the staircase structure 702, providing a smooth transition between the steps and ensuring electrical isolation between the layers.

After the oxide layer 802 is deposited, a CMP process is performed to planarize the surface. CMP involves polishing the stack 602 surface using a rotating pad and a slurry containing abrasive particles. The combination of mechanical action and chemical reaction removes excess oxide and any topographical variations, creating a flat, smooth surface that is essential for the next stages of fabrication. The planarized oxide layer 802 ensures that the staircase structure 702 is well-defined, with each step providing a clean, isolated landing pad for the formation of electrical contacts.

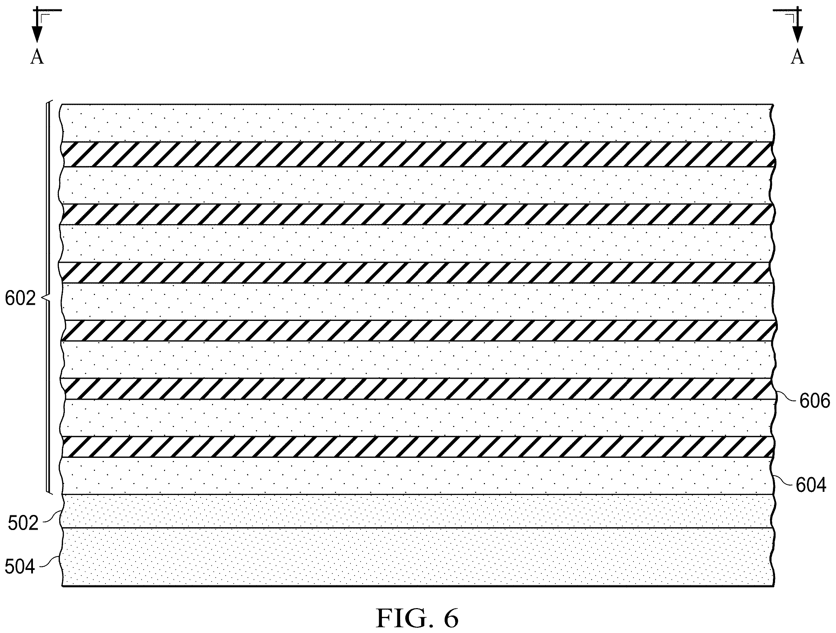

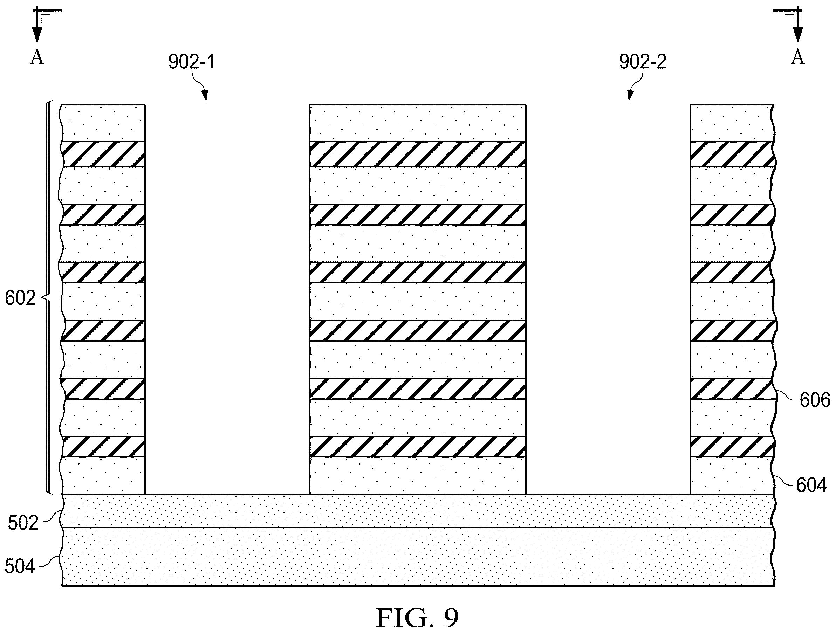

Referring back to the portion of the stack 602 illustrated in FIG. 6, FIG. 9 shows that, after the formation of the staircase structure 702 is completed, trenches 902 or channel holes (such as trench 902-1 and trench 902-2) are etched through the stack 602. These trenches 902 define the vertical paths where the MTJs 108 and bitlines 130 will later be formed. In at least some embodiments, the etching process involves depositing a new photoresist layer across the surface of the stack 602. Photolithography is employed to pattern the photoresist, defining the locations where the trenches 902 will be etched. A photomask is used to selectively expose the photoresist to UV light in the areas corresponding to the desired channel locations. After exposure, the photoresist is developed, creating openings in the resist layer that outline the channel etch pattern.

With the photoresist pattern in place, RIE is utilized to etch the trenches 902 through the stack 602. During this process, reactive gases, such as CF₄, SF₆, or trifluoromethane (CHF₃), are introduced into the etch chamber to generate a plasma. The ions in the plasma are accelerated toward the wafer surface, where they react with the exposed regions of the sacrificial layers 604, 606, removing material and creating vertical channels. The anisotropic nature of RIE allows for highly directional etching, producing channels with well-defined vertical sidewalls. In at least some embodiments, the etching process extends through the entire thickness of the stack 602 down to the underlying CMOS layer 502.

After the trenches 902 are etched, the remaining photoresist is removed using a stripping process involving, for example, a plasma ashing step followed by a wet chemical clean. The result is an array of trenches (vertical channels) within the stack 602, extending from the top of the stack 602 down to the CMOS layer 502. These trenches 902 define the locations where the MTJ structures 108 will be formed in subsequent steps, allowing for the creation of a dense, vertically integrated 3D MRAM array 102.

FIG. 10 shows that after the trench 902 has been etched into stack 602, MTJ films are deposited within these trenches 902. Unlike conventional planar processes, this deposition involves forming the MTJ layers on the vertical sidewalls (z-direction in view depicted in FIG. 9) of the trenches 902. This approach allows for the vertical integration of the MTJs 108 within the 3D MRAM structure. The process involves sequentially depositing the free layer 110 (illustrated as free layers 110-1 and 110-2), pinned layer 112 (illustrated as pinned layers 112-1 and 112-2), and tunnel barrier 114 (illustrated as tunnel barrier 114-1 and tunnel barrier 114-2) along the vertical walls.

In at least some embodiments, the deposition begins with the conformal deposition of the free layer 110. This layer 110, in at least some embodiments, is comprised of a ferromagnetic material, such as CoFeB. A conformal deposition technique, such as atomic layer deposition (ALD) or sputtering with specific parameters, is employed to ensure uniform coverage over both the vertical and horizontal surfaces within the trench 902. During ALD, alternating pulses of, for example, a cobalt precursor and a boron precursor are introduced into the reaction chamber, reacting with the surface to form a thin, uniform layer of CoFeB.

Next, the tunnel barrier 114 is deposited. Again, ALD is used to achieve a conformal coating on the vertical sidewalls of the free layer 110. In at least some embodiments, the process involves alternating pulses of tunnel barrier materials, such as a magnesium precursor and an oxidizing agent (e.g., water vapor or oxygen plasma), to form, for example, a uniform magnesium oxide layer. The pinned layer 112 is then deposited conformally over the tunnel barrier 114. The tunnel barrier 114, in at least some embodiments, includes a synthetic antiferromagnet (SAF) structure, which may include materials like cobalt iron (CoFe) and ruthenium (Ru). The conformal deposition process, which includes either ALD or sputtering, ensures that the pinned layer 112 forms a uniform coating over the tunnel barrier 114.

In at least some embodiments, after the conformal deposition of all three layers, an anisotropic etching process is performed to remove these films from the horizontal surfaces, leaving the layers only on the vertical sidewalls of the trenches 902. RIE can be used for this etching process, as it provides highly directional etching. During RIE, reactive gases, such as argon or a combination of fluorine-based chemistries, are introduced into the chamber. The ions in the plasma are directed perpendicularly towards the stack 602, selectively removing material from the horizontal planes while preserving the MTJ films on the vertical walls of the trenches 902. The result is a vertical stack of the free layer 110, tunnel barrier 114, and pinned layer 112 within each trench 902. These MTJ structures are now confined to the vertical sidewalls, with the horizontal surfaces of the stack 602 cleared of these materials.

FIG. 10 also shows that following the formation of the MTJ layers on the vertical sidewalls of the trenches 902, a bitline 130 (illustrated as bitline 130-1 and bitline 130-2) is formed within the trench 902. In at least some embodiments, this process begins with the deposition of a thin adhesion layer (not shown), such as titanium or titanium nitride. This layer promotes adhesion between the MTJ structure and the subsequent metal layer, ensuring a stable interface and reducing the risk of delamination. In other embodiments, the adhesion layer is not formed. In at least some embodiments, sputtering is used to deposit the adhesion layer.

Once the adhesion layer is in place, the conductive material, such as tungsten or copper, for the bitline 130 is deposited. In at least some embodiments, PVD or CVD methods are used for this deposition process. After the bitline material is deposited, a planarization step is performed to ensure a flat and smooth surface. For example, CMP is used to remove excess material and achieve a uniform surface. The CMP process stops at the top of the stack 602.

FIG. 11 shows that after the formation of the bitline 130 (bottom electrode), an isolation etch is performed to define and isolate MRAM array structures 1102 (illustrated as structure 1102-1 and structure 1102-2). In at least some embodiments, this process involves the application of a photoresist layer over the entire stack 602. Photolithography is used to pattern the photoresist, creating a mask that exposes only the regions where material needs to be removed. The photomask used in this process defines the boundaries of each MRAM array 102, ensuring that the etching process selectively removes material from the spaces between the bitlines 130 while leaving the MTJ materials and the bitlines 130 intact. After UV light exposure through the photomask and subsequent development, the patterned photoresist serves as a protective layer for the areas that should not be etched.

With the photoresist mask in place, an anisotropic RIE process is employed to remove the unwanted materials. The highly directional nature of RIE ensures that the etching primarily occurs in the vertical direction, preserving the lateral dimensions of the MTJ and bitline materials and providing sharp, well-defined edges. After the etching is complete, the remaining photoresist mask is stripped away using a plasma ashing process or a wet chemical clean. This leaves behind a well-defined array of isolated MRAM arrays structures 1102, each separated by an isolation trench 1104.

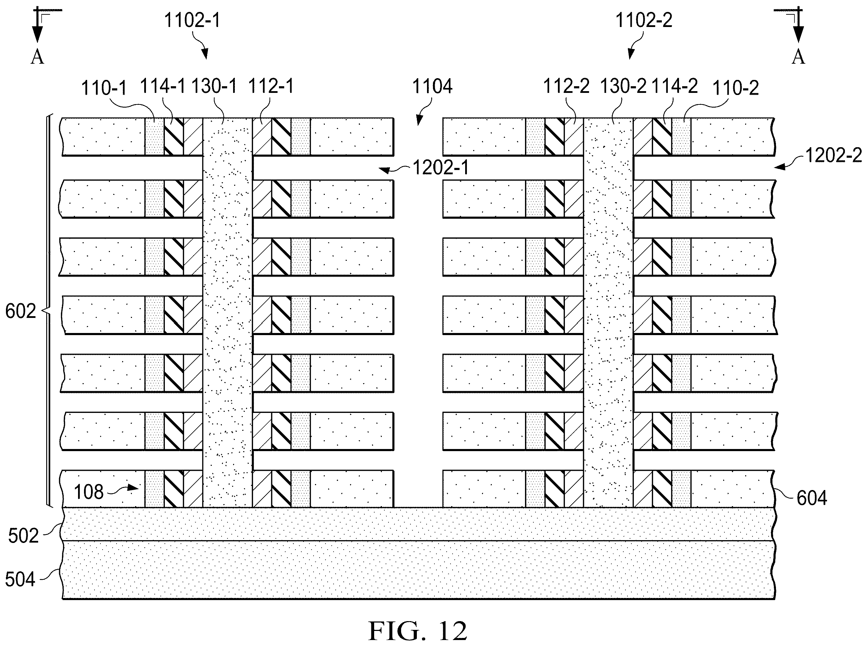

FIG. 12 shows that following the formation of the trench 1104, a selective etching process is performed to remove the second sacrificial layers 606 of the stack 602 and the adjacent portions of the MTJ layers (free layer 110, tunnel barrier 114, and pinned layer 112) within the stack 602 while preserving the vertical bitline 130. The etch chemistry is configured to have high selectivity for the materials of the second sacrificial layers 606 and the materials relative to the bitline material. These metals are generally resistant to certain etchants, allowing the etching process to remove the targeted second sacrificial and MTJ materials while leaving the bitline 130 and the first sacrificial layers 604 intact.

In at least some embodiments, an anisotropic RIE process is used for the selective etching process. The process leverages the previously formed trench 1104 to guide the etching, targeting only the second sacrificial layers 604 and their adjacent MTJ portions exposed by the trench 1104. The first sacrificial layers 604 and the bitline 130 remain unaffected by this etching process due to the inherent resistance of their materials to the etching chemistry used. As a result, the etch selectively removes the second sacrificial layers 606 and their adjacent portions of the MTJ layers on either side of the bitline 130, creating well-defined cavities 1202 (illustrated as cavities 1202-1 and cavities 1202-2) and isolated MTJs stacks 108.

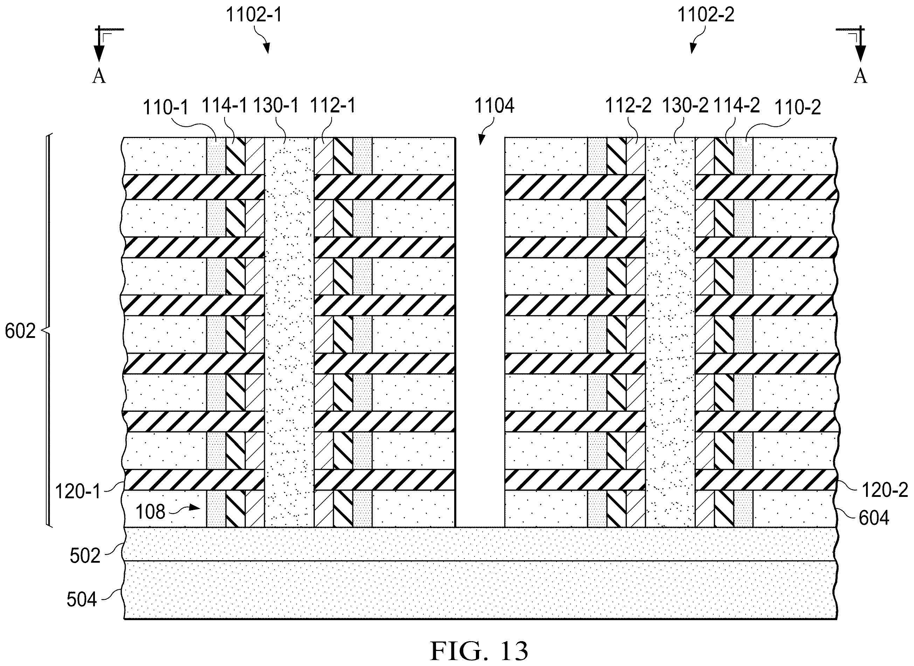

FIG. 13 shows that after the formation of the cavities 1202, an encapsulation and isolation process is performed. This process deposits a material to fill the cavities 1202 around the MTJ structures 108 and form insulation layers 120. These insulating layers 120 provide electrical isolation and protection for the MTJ structures 108. In at least some embodiments, this process involves the deposition of a conformal dielectric layer, such as silicon nitride or silicon dioxide, using a technique such as CVD or ALD. This material acts as both an encapsulation and isolation layer. The fill material is deposited rather than maintain the second sacrificial layer 606 because if the second sacrificial material 606 is not completely removed, the adjacent portions of the MTJ structures 108 would remain connected or shorted together. This would prevent proper electrical isolation, causing interference between neighboring MTJ cells. By removing the sacrificial material and replacing it with a dielectric material, the process ensures that each MTJ structure 108 is encapsulated and electrically isolated from its neighbors. The dielectric material fills the cavities 1202 created by the removal of the second sacrificial layers 606 and adjacent MTJ portions. After deposition, the excess dielectric material is removed from unwanted areas. For example, a CMP process is performed to selectively remove the dielectric material from the top of the stack 602 and from within the trench 1104, leaving the insulating layer 120 (illustrated as insulating layer 120-1 and insulating layer 120-2) only within the cavities 1202 around the MTJ structures 108.

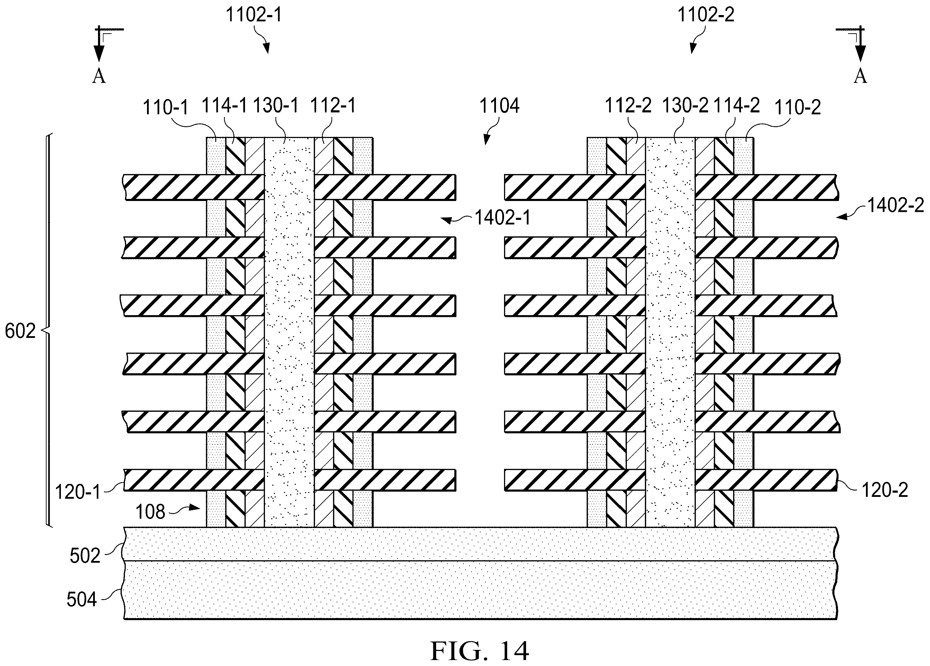

FIG. 14 shows that, following the encapsulation and isolation of the MTJs 108, another selective etching process is performed to selectively remove the first sacrificial layers 604 to form cavities 1402 (illustrated as cavities 1402-1 and cavities 1402-2) within the stack 602. These cavities 1402 will be later filled with material to create the wordline connectors 116 (illustrated as wordline connector 116-1 and wordline connector 116-2) for MRAM cells 106. In at least some embodiments, this involves an etching technique that is highly selective to the material of the first sacrificial layers 604, allowing these layers 604 to be removed without affecting the surrounding insulating layers 120, MTJ structures 108, or the bitline 130.

A first sacrificial layer 604 comprising a material such as silicon dioxide is used rather than depositing wordline material in place of the first sacrificial layer 604. This approach is implemented because, if the wordline material (typically metal) were used, it would likely present challenges during the removal of the second sacrificial layers and adjacent MTJ portions. Specifically, since the wordline material would be similar to the metal used in the MTJ structures 108, the wordline material would likely be attacked or damaged during the etching process for the second sacrificial layers. Using a non-metal sacrificial material, such as silicon dioxide, and incorporating an extra processing step ensures that the wordline metal remains intact and unaffected. A dry plasma etch, a wet chemical etch, or another process is configured to target the material of the first sacrificial layers 604, selectively removing them while preserving the surrounding structures. As the first sacrificial layers 604 are removed, the resulting cavities 1402 provide the necessary space for the subsequent formation of the wordline connectors 116.

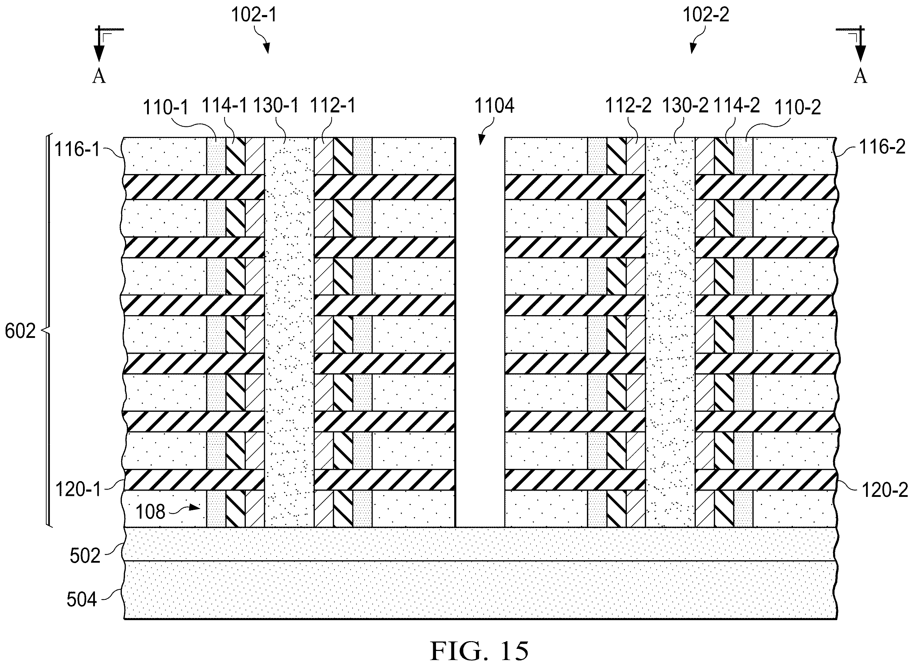

FIG. 15 shows that the first sacrificial layers 604 have been selectively removed, wordline connectors 116 are formed within the cavities 1402. In at least embodiments, this process involves the deposition of a conductive material into the cavities 1402. Examples of conductive materials include tungsten, titanium nitride, or a combination of metals such as titanium followed by tungsten. The deposition, in at least some embodiments, is performed using techniques such as CVD or PVD to deposit a conformal layer of material within the cavities 1402.

Once the conductive material is deposited and the cavities 1402 are filled, an anisotropic dry etching process, such as RIE, is used to remove the conductive material from the trench 1104. This process is highly directional, targeting the vertical sidewalls and bottom of the trench 1104 to clear the conductive material without disturbing the material within the cavities 1402. After the dry etching process, a planarization process, such as CMP, is performed to remove the excess conductive material from the surface of the stack 602. These etching and polishing processes leave the wordline connectors 116 only within the cavities 1402 and in direct contact with the free layer 110 of the MTJ structures 108. At this point in the fabrication, the MRAM arrays 102 are now formed.

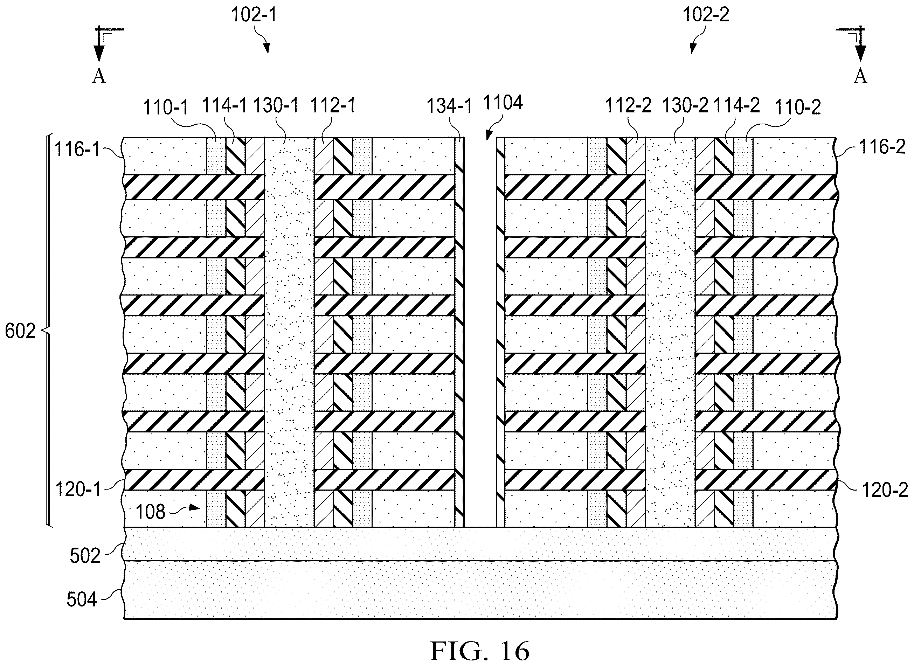

FIG. 16 shows that after the wordline connectors 116 have been formed, a liner oxide layer 140 is formed in the isolation trench 1104. The liner oxide layer 140 electrically isolates the bitlines 130 of adjacent MRAM arrays 102. In at least some embodiments, this process involves the deposition of a cap oxide material, such as silicon dioxide, using a conformal deposition technique, such as CVD or ALD. After the conformal oxide deposition, CMP is used to remove the excess oxide material from the top surface of the stack 602. In at least some embodiments, MTJ structures 108 and portions of the bitline 130 covered by the oxide material at the top of the stack 602 are removed by the CMP process.

After CMP, an anisotropic dry etching process, such as RIE, is performed to selectively remove the oxide from the bottom of the trench 1104, leaving the oxide only on the vertical sidewalls. These processes ensure that the oxide remains only where it is needed to provide electrical isolation between the bitlines 130 of adjacent MRAM arrays 102. The result of these processes is a liner oxide layer 140 on the vertical sidewalls of the isolation trench 1104.

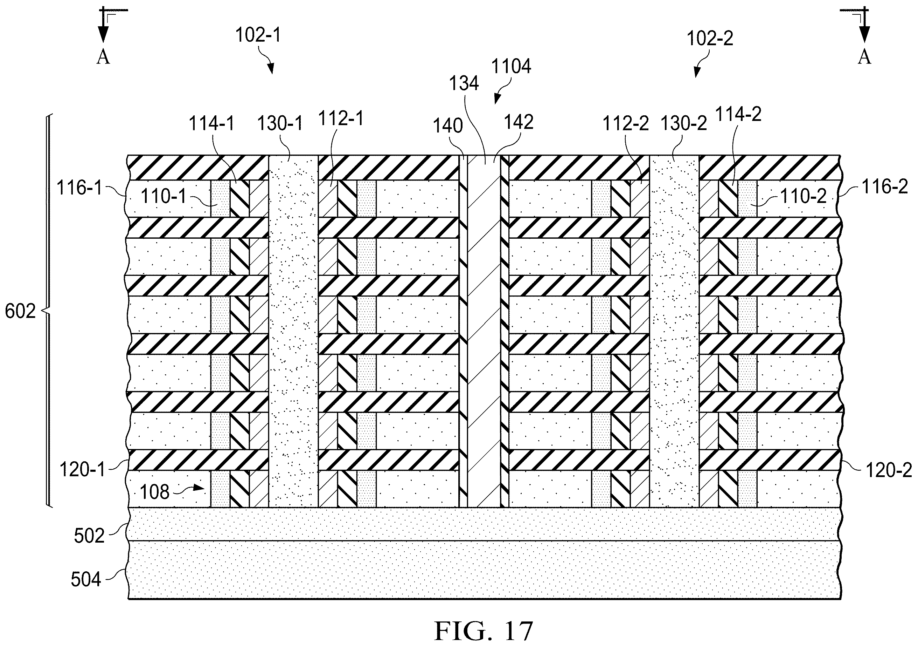

FIG. 17 shows that after the liner oxide layer 140 has been formed, a stress relief fill material 142 is deposited within the trench 1104 in contact with the liner oxide layer 140. The liner oxide layer 140 and the stress relief fill material 142 form the isolation layer 134. In at least some embodiments, one or more materials, such as titanium nitride and tungsten, are deposited over the entire structure to fill the isolation trench 1104 using, for example, PVD or ALD.

Following the deposition of the stress relief fill material 142, CMP and selective etching processes are performed. For example, CMP is performed to remove excess stress relief fill material 142 from the top of the stack 602, leaving the material within the trench 1104. After CMP, any residual stress relief fill material 142 that might still be present on the top surface or at the trench edges is removed using a selective etching process. This step ensures that stress relief fill material 142 is fully confined within the trench 1104 between the liner oxide layer 140.

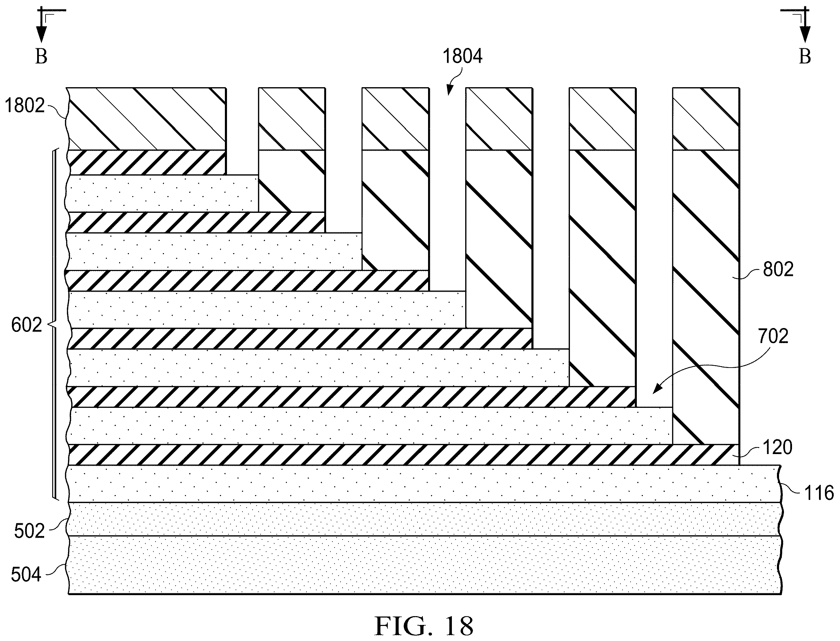

FIG. 18 shows that after the isolation layer 134 has been completed, a contact etching process is performed on the staircase structure 702 of FIG. 7. In at least some embodiments, this process involves applying a photoresist layer 1802 over the entire MRAM array 102, including the staircase structure 702. Photolithography is used to pattern the photoresist, exposing specific regions where contact vias need to be formed. A photomask configured with the desired pattern is aligned over the staircase structure 702, and UV light is used to expose the photoresist 1802. The exposed regions of the photoresist 1802 are then developed, revealing the areas of the staircase structure 702 that will be etched to create the contact vias.

Following the photolithography process, an anisotropic RIE process is employed to etch through the exposed layers insulating layers 120 of the staircase structure. The anisotropic nature of RIE ensures that the etching occurs primarily in the vertical direction, creating well-defined contact vias 1804 through the layers 120 and oxide layer 802. As the etching progresses, the contact vias 1804 are formed through each step of the staircase structure 702, reaching down to the wordline connectors 116 where electrical contacts are to be formed. Once the etching is complete, the photoresist 1802 is removed using a plasma ashing process or a wet chemical clean. This leaves behind the staircase structure 70 with well-defined contact vias 1804 that extend through the insulating layers 120 to the intended connection points on the wordline connectors 116.

As shown in FIG. 19, a back-end-of-line process is performed to form electrical contacts 1902 (FIG. 1A and FIG. 19) to the wordline connectors 116. In at least some embodiments, this process includes the deposition of a barrier and adhesion layer material, such as titanium nitride. For example, using PVD or ALD, a conformal layer of titanium nitride is deposited over the entire structure, including the exposed contact vias 1804 etched in the staircase structure 702. The TiN layer ensures a strong adhesion between the conductive material that will be deposited next and the underlying materials, as well as acting as a diffusion barrier.

Next, a layer of conductive material, such as tungsten is deposited over the TiN-coated structure using, for example, CVD. This conductive layer fills the contact vias 1804, forming a solid electrical pathway to the wordline connectors 116 exposed in the staircase structure 702. After the deposition of adhesion and conductive layers, excess material covers the top of the structure, including the surface of the staircase structure 702. To isolate the contacts 1902 and ensure they remain only within the defined vias 1804, a CMP process is performed to remove the excess materials from the top surface of the structure, leaving the conductive material only within the contact vias 1902.

Upon completion of this process, the wordline connectors 116 are now electrically accessible from the top (in the orientation shown in FIG. 19) of the device. Above this planarized surface, one or more metal interconnect layers, e.g., M1 layer 1904, M2 layer 1906, and M3 layer 1908, are formed. Within these metal layers, a wordline(s) (not shown in FIG. 19) is routed horizontally (in the orientation shown in FIG. 19). The wordline connectors 116 interface with these wordlines through the vertical contacts 1902, providing a direct electrical connection from the top-level metal routing structure down to the side of the MTJ cells 106. Thus, signals can be routed from a driving circuit (not shown) through the M1/M2/M3 metal layers into these wordlines, and then through the contact vias 1902 to the wordline connectors 116, enabling precise control of individual cells during read/write operations.

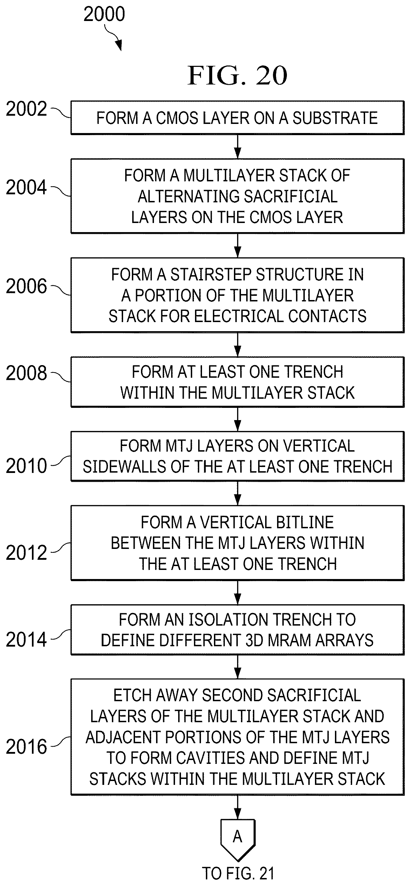

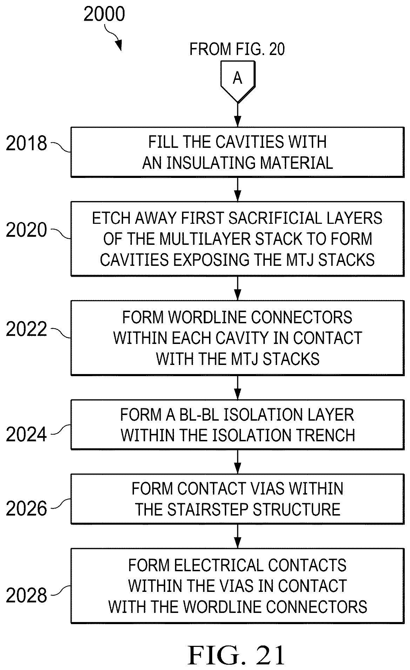

FIG. 20 and FIG. 21 together are a diagram illustrating an example method 2000 of fabricating a 3D MRAM device according to one or more embodiments. It should be understood that the processes described below with respect to method 2000 have been described above in greater detail with reference to FIG. 1 to FIG. 19. The method 2000 is not limited to the sequence of operations shown in FIG. 20 and FIG. 21, as at least some of the operations can be performed in parallel or in a different sequence. Moreover, in at least some embodiments, the method 200 can include one or more different operations than those shown in FIG. 20 and FIG. 21.

At block 2002, a CMOS layer 502 is formed on a substrate 504. At block 2004, a multilayer stack 602 of alternative sacrificial layers 604, 606 is formed on the CMOS layer 502. At block 2006, a staircase structure 702 is formed in a portion 704 of the stack 602 for electrical contacts. In other embodiments, the staircase structure is formed after formation of the bitline 130 at block 2012 and before the isolation trench 1104 at block 2014. At block 2008, at least one trench 902 is formed within the stack 602. At block 2010, lateral MTJ layers (free layer 110, tunnel barrier 114, and pinned layer 112) are formed on vertical sidewalls of the at least one trench 902. At block 2012, a bitline 130 is formed within the at least one trench 902 between the pinned layers 112. At block 214, an isolation trench 1104 is formed within the stack 602 to define and isolate multiple 3D MRAM arrays 102.

At block 2016, second sacrificial layers 606 of the stack 602 and adjacent portions of the MTJ layers are etched away to form cavities 1202 and define MTJ structures 108 within the stack 602. This etching process also exposes exposing a corresponding portion of the bitline 130 in each of the cavities 1202. At block 2018, the cavities 1202 are filled within an insulating material to form insulating layers in contact with the corresponding portion of the bitline 130. At block 2020, first sacrificial layers 604 of the stack 602 are etched away to form cavities 1402, exposing at least a first layer (e.g., the free layer 110) of the MTJ structures 108. At block 2022, wordline connectors 116 are formed within each of these cavities 1402 and contact the first layer of the MTJ structure 108. At block 2024, an isolation layer 134 is formed within the isolation trench 1104. At block 2026, contact vias 1804 are formed within the staircase structure 702 formed at block 2206. At block 2028, electric contacts 1902 are then formed within the vias 1804.

Note that not all of the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

The present disclosure extends to a method for fabricating a three-dimensional (3D) magnetoresistive random access memory (MRAM) structure, comprising: forming a multilayer stack of alternating first sacrificial layers and second sacrificial layers; forming at least one trench in the multilayer stack; forming lateral magnetic tunnel junction (MTJ) layers on vertical sidewalls of the at least one trench; forming a first interconnect structure of a first type in the at least one trench in contact with a first layer of the lateral MTJ layers; and forming a plurality of MRAM cells within the multilayer stack, each MRAM cell of the plurality of MRAM cells comprising a second interconnect structure of a second type and a lateral MTJ structure composed of a portion of each layer of the lateral MTJ layers, the second interconnect structure contacting a second layer of the lateral MTJ layers.

In one or more embodiments, forming the lateral MTJ layers comprises: forming the second layer in contact with the vertical sidewalls of the at least one trench; forming a third layer in contact with vertical sidewalls of the second layer; and forming the first layer in contact with vertical sidewalls of the third layer.

In one or more embodiments, the first layer is a magnetic layer having a fixed magnetization state, the second layer is a magnetic layer having a variable magnetization state, and the third layer is an insulating layer.

In one or more embodiments, forming the plurality of MRAM cells within the multilayer stack comprises: etching away the first sacrificial layers and adjacent portions of the lateral MTJ layers, the etching forming first cavities between the second sacrificial layers and exposing a corresponding portion of the first interconnect structure in each of the first cavities, the etching leaving remaining portions of the lateral MTJ layers forming the lateral MTJ structure of each MRAM cell of the plurality of MRAM cells; and forming an insulating layer in each of the first cavities and in contact with the corresponding portion of the first interconnect structure.

In one or more embodiments, forming the plurality of MRAM cells within the multilayer stack further comprises: etching away the second sacrificial layers to define each MRAM cell of the plurality of MRAM cells, the etching forming second cavities between each insulating layer and exposing the lateral MTJ structure of the MRAM cell; and forming, for each second cavity, the second interconnect structure in second cavity in contact with the lateral MTJ structure exposed by the second cavity.

In one or more embodiments, the method further comprises: forming a staircase structure in a portion of the multilayer stack; depositing a dielectric layer over the staircase structure; forming vias within the dielectric layer exposing the second interconnect structure of each MRAM cell of the plurality of MRAM cells; and filling the vias with a conductive material to form a plurality of electrical contacts each in contact with the second interconnect structure of one MRAM cell of the plurality of MRAM cells.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A three-dimensional, 3D, magnetoresistive random access memory, MRAM, device, comprising:
a first plurality of cells stacked in a direction perpendicular to a major surface of a substrate of the MRAM device, each cell of the first plurality of cells comprising a magnetic tunnel junction, MTJ, structure and a first interconnect structure of a first type configured to interface with the MTJ structure of the cell, and each cell of the first plurality of cells separated by an insulating layer of a first plurality of insulating layers from another cell of the first plurality of cells; and
a second interconnect structure of a second type oriented orthogonally to the first interconnect structure of each cell of the first plurality of cells, the second interconnect structure extending through the first plurality of cells to interface with the MTJ structure in each cell of the first plurality of cells.

2. The 3D MRAM device of claim 1, wherein the MTJ structure of each cell comprises:
a first magnetic layer having a variable magnetization state;
a second magnetic layer having a fixed magnetization state; and
an insulating layer disposed between the first magnetic layer and the second magnetic layer.

3. The 3D MRAM device of claim 2, wherein for each cell of the first plurality of cells, the first interconnect structure is a wordline connector that directly interfaces with the first magnetic layer and further interfaces with an access line of the MRAM device, and the second interconnect structure is a bitline that directly interfaces with the second magnetic layer.

4. The 3D MRAM device of claim 2 or 3, wherein for each cell of the first plurality of cells, the first interconnect structure is a wordline connector that directly interfaces with the second magnetic layer and the second interconnect structure is a bitline that directly interfaces with the first magnetic layer.

5. The 3D MRAM device of claim 2, wherein for each cell of the first plurality of cells, the first interconnect structure is a bitline connector that directly interfaces with the first magnetic layer and the second interconnect structure is a wordline that directly interfaces with the second magnetic layer.

6. The 3D MRAM device of claim 2 or 5, wherein for each cell of the first plurality of cells, the first interconnect structure is a bitline connector that directly interfaces with the second magnetic layer and the second interconnect structure is a wordline that directly interfaces with the first magnetic layer.

7. The 3D MRAM device of any of claims 2 to 6, wherein each of the first magnetic layer, the second magnetic layer, and the insulating layer of the MTJ structure of each cell has at least one major surface that is parallel with respect to one another and is oriented perpendicular with the major surface of the substrate.

8. The 3D MRAM device of any preceding claim, further comprising:
a selector transistor coupled to the second interconnect structure and a select line configured to activate the selector transistor.

9. The 3D MRAM device of claim 8, further comprising:
a sense amplifier coupled to the second interconnect structure via the selector transistor.

10. The 3D MRAM device of any preceding claim, further comprising:
a second plurality of cells stacked in a direction perpendicular to the major surface of the substrate, each cell of the second plurality of cells comprising an MTJ structure and a third interconnect structure of the first type configured to interface with the MTJ structure of the cell, and each cell of the second plurality of cells separated by an insulating layer of a second plurality of insulating layers from another cell of the second plurality of cells; and
a fourth interconnect structure of the second type oriented orthogonally to each access interconnect of each cell of the second plurality of cells, the fourth interconnect structure extending through the second plurality of cells to interface with the MTJ structure in each cell of the second plurality of cells.

11. The 3D MRAM device of claim 10, further comprising:
an isolation layer disposed between the second interconnect structure and the fourth interconnect structure.

12. A three-dimensional, 3D, magnetoresistive random access memory, MRAM, device, comprising:
a first plurality of cells stacked in a direction perpendicular to a major surface of a substrate of the MRAM device, each cell of the first plurality of cells separated by an insulating layer of a first plurality of insulating layers from another cell of the first plurality of cells, and each cell of the first plurality of cells comprising a wordline connector and a magnetic tunnel junction, MTJ, structure, the MTJ structure comprising:
a first magnetic layer having a variable magnetization state and directly interfacing with the wordline connector,
a second magnetic layer having a fixed magnetization state, and
an insulating layer disposed between the first magnetic layer and the second magnetic layer; and
a first bitline oriented orthogonally to each wordline connector of each cell of the first plurality of cells, the first bitline extending through the first plurality of cells and directly interfacing with a second magnetic layer of the MTJ structure in each cell of the first plurality of cells.

13. The 3D MRAM device of claim 12, further comprising:
a second plurality of cells stacked in a direction perpendicular to the major surface of the substrate, each cell of the second plurality of cells is separated by an insulating layer of a second plurality of insulating layers from another cell of the second plurality of cells, and each cell of the second plurality of cells comprising an MTJ structure and a wordline connector configured to directly interface with the MTJ structure of the cell; and
a second bitline oriented orthogonally to each access interconnect of each cell of the second plurality of cells, the second bitline extending through the second plurality of cells to interface with the MTJ structure in each cell of the second plurality of cells.

14. The 3D MRAM device of claim 13, further comprising:
an isolation layer disposed between the first bitline and the second bitline.

15. A method for fabricating a three-dimensional, 3D, magnetoresistive random access memory, MRAM, structure, comprising:
forming a multilayer stack of alternating first sacrificial layers and second sacrificial layers;
forming at least one trench in the multilayer stack;
forming lateral magnetic tunnel junction, MTJ, layers on vertical sidewalls of the at least one trench;
forming a first interconnect structure of a first type in the at least one trench in contact with a first layer of the lateral MTJ layers; and
forming a plurality of MRAM cells within the multilayer stack, each MRAM cell of the plurality of MRAM cells comprising a second interconnect structure of a second type and a lateral MTJ structure composed of a portion of each layer of the lateral MTJ layers, the second interconnect structure contacting a second layer of the lateral MTJ layers.
